# EUROPÄISCHE PATENTANMELDUNG

(11) **EP 4 819 778 A1**
(43) Veröffentlichungstag der Anmeldung: **07.10.2026**
(21) Anmeldenummer: 25167932.0
(22) Anmeldetag: 02.04.2025
(51) Int. Cl.: H05K 5/00

(54) **ELEKTRISCHE BAUGRUPPE UND VERFAHREN ZUR MONTAGE EINER ELEKTRISCHEN BAUGRUPPE**

(71) Anmelder: Rosenberger Hochfrequenztechnik GmbH & Co. KG, 83413 Fridolfing (DE); Endress+Hauser SE+Co. KG, 79689 Maulburg (DE)
(72) Erfinder: Schichl, Markus, 83413 Fridolfing (DE); Huber, Simon, 83413 Fridolfing (DE); Margardt, Markus, 83413 Fridolfing (DE); Gerwig, Simon, 79689 Maulburg (DE); Brock, Hansjörg, 79689 Maulburg (DE); Strittmatter, Christian, 79689 Maulburg (DE); Schonhardt, Raphael, 79689 Maulburg (DE)
(74) Vertreter: Lorenz & Kollegen

(57) **Zusammenfassung**

Die Erfindung betrifft eine elektrische Baugruppe (3), aufweisend ein Baugruppengehäuse (1), wenigstens eine in dem Baugruppengehäuse (1) aufgenommene elektrische Schaltungsanordnung (2) und einen elektrischen Verbinder (7), der eine Verbindungsschnittstelle (12) aufweist, die elektrisch und mechanisch mit einem korrespondierenden Anschlussbereich (13) der elektrischen Schaltungsanordnung (2) verbunden ist. Der elektrische Verbinder (7) ist durch eine Montagedurchführung (8) des Baugruppengehäuses (1) hindurchgeführt. Es ist vorgesehen, dass sich die Verbindungsschnittstelle (12) des elektrischen Verbinders (7) und der Anschlussbereich (13) der elektrischen Schaltungsanordnung (2) kraftschlüssig kontaktieren.

## Beschreibung

Die Erfindung betrifft eine elektrische Baugruppe, aufweisend ein Baugruppengehäuse, wenigstens eine in dem Baugruppengehäuse aufgenommene elektrische Schaltungsanordnung und einen elektrischen Verbinder, gemäß dem Oberbegriff des Anspruchs 1.

Die Erfindung betrifft ferner ein Verfahren zur Montage einer elektrischen Baugruppe, gemäß dem Oberbegriff des Anspruchs 15.

Bei einer elektrischen Baugruppe handelt es sich im Allgemeinen um eine Zusammenstellung von elektrischen bzw. elektronischen Komponenten. Eine elektrische Baugruppe wird oft in grö-ßere Systeme integriert, um spezifische Aufgaben zu erfüllen, wie etwa in Haushaltsgeräten, Computern, Fahrzeugen oder Industriemaschinen. Typische Beispiele für elektrische Baugruppen sind Netzteile, Steuermodule, Kommunikationsmodule und Sensormodule. Eine elektrische Baugruppe umfasst in der Regel eine Schaltungsanordnung aus elektrischen Bauelementen, wie unter anderem Widerstände, Kondensatoren, Spulen, Dioden, Transistoren und integrierte Schaltkreise (ICs), die zumeist auf einer oder mehreren gemeinsamen Trägerplatten angeordnet sind, insbesondere auf elektrischen Leiterplatten (PCBs). Elektrische Baugruppen umfassen häufig ein Baugruppengehäuse, um die elektronischen Bauteile in einer definierten Anordnung zu fixieren und elektrisch und/oder mechanisch gegen äußere Einflüsse zu schützen.

Die Stromversorgung sowie der Austausch elektrischer Datensignale mit der elektrischen Baugruppe erfolgt in der Praxis häufig über elektrische Verbinder, die durch das Baugruppengehäuse hindurchgeführt sind und innerhalb des Baugruppengehäuses mit der elektrischen Schaltung verbunden werden müssen. Häufig kommen Leiterplattensteckverbinder zum Einsatz, um eine auf einer Leiterplatte angeordnete elektrische Schaltung von außerhalb des Baugruppengehäuses elektrisch zugänglich zu machen. Die Leiterplattensteckverbinder werden hierzu auf entsprechenden Kontaktflächen und/oder in Durchkontaktierungen ("Vias") der Leiterplatte verlötet.

Die Montage der elektrischen Verbinder auf der Leiterplatte gestaltet sich in der Praxis oft als aufwändig. Denn elektrische Baugruppen und deren Baugruppengehäuse sind mitunter kompakt gestaltet, um Platz zu sparen und Kosten zu reduzieren. Dies erschwert den Zugang zu den elektrischen Schaltungen und damit die Montierbarkeit der elektrischen Verbinder. Insbesondere ist es zumeist problematisch, die elektrischen Verbinder einerseits mit der elektrischen Leiterplatte zu verlöten und anschließend noch durch das Baugruppengehäuse hindurchzuführen. In der Praxis müssen die Baugruppengehäuse daher in der Regel entweder nachteilig in Übergröße oder alternativ mehrteilig ausgebildet werden. Bei einem mehrteiligen Baugruppengehäuse, insbesondere bei einer Verbindungsstelle der Gehäuseteile im Bereich der Montagedurchführung des elektrischen Verbinders, besteht dann das Risiko, dass Dichtigkeitsanforderungen, eine ggf. erforderliche elektromagnetische Abschirmung und/oder mechanische Belastungsanforderungen nicht mehr ausreichend sichergestellt sein können.

Dies ist ein Zustand, den es zu verbessern gilt.

In Anbetracht des bekannten Standes der Technik besteht die Aufgabe der vorliegenden Erfindung darin, eine elektrische Baugruppe bereitzustellen, die einfach und kostengünstig montierbar ist, bei vorzugsweise kompakter und robuster Bauweise.

Der vorliegenden Erfindung liegt auch die Aufgabe zugrunde, ein einfach und kostengünstig durchführbares Verfahren zur Montage einer elektrischen Baugruppe bereitzustellen, vorzugsweise für eine elektrische Baugruppe mit kompakter und robuster Bauweise.

Die Aufgabe wird für die elektrische Baugruppe mit den in Anspruch 1 aufgeführten Merkmalen gelöst. Hinsichtlich des Verfahrens wird die Aufgabe durch die Merkmale des Anspruchs 15 gelöst.

Die abhängigen Ansprüche und die nachfolgend beschriebenen Merkmale betreffen vorteilhafte Ausführungsformen und Varianten der Erfindung.

Es ist eine elektrische Baugruppe vorgesehen, aufweisend ein Baugruppengehäuse, wenigstens eine in dem Baugruppengehäuse aufgenommene elektrische Schaltungsanordnung und wenigstens einen elektrischen Verbinder. Der elektrische Verbinder weist wenigstens eine Verbindungsschnittstelle auf, die elektrisch und mechanisch mit einem korrespondierenden Anschlussbereich der elektrischen Schaltungsanordnung verbunden ist.

Grundsätzlich kann die elektrische Baugruppe eine beliebige Anzahl elektrischer Schaltungsanordnungen aufweisen, beispielsweise genau eine, zwei, drei, vier, fünf, sechs oder noch mehr elektrische Schaltungsanordnungen. Die Erfindung wird nachfolgend anhand einer elektrischen Baugruppe beschrieben, die genau eine elektrische Schaltungsanordnung aufweist, was allerdings nicht einschränkend zu verstehen ist.

Die elektrische Baugruppe kann genau einen, aber auch mehrere elektrische Verbinder aufweisen, beispielsweise zwei, drei, vier, fünf, sechs oder noch mehr elektrische Verbinder. Die elektrischen Verbinder können auf mehrere elektrische Schaltungsanordnungen verteilt sein, wobei allerdings auch vorgesehen sei kann, dass eine einzige elektrische Schaltungsanordnung mit mehreren elektrischen Verbindern verbunden ist. Die Erfindung wird nachfolgend beispielhaft anhand einer elektrischen Baugruppe beschrieben, die nur einen einzigen elektrischen Verbinder aufweist, was allerdings nicht einschränkend zu verstehen ist.

Insbesondere sei betont, dass auch vorgesehen sein kann, dass ein elektrischer Verbinder mit mehreren elektrischen Schaltungsanordnungen elektrisch und mechanisch verbunden ist. Der elektrische Verbinder kann dann pro Schaltungsanordnung eine jeweilige Verbindungsschnittstelle oder eine gemeinsame Verbindungsschnittstelle für mehrere Schaltungsanordnungen aufweisen. Vorzugsweise sind die elektrischen Schaltungsanordnungen, mit denen der gemeinsame elektrische Verbinder verbunden ist, hierfür parallel zueinander angeordnet. Auch eine winklige Anordnung bis hin zu einer orthogonalen Anordnung der elektrischen Schaltungsanordnungen kann grundsätzlich allerdings möglich sein.

Erfindungsgemäß ist vorgesehen, dass der elektrische Verbinder durch eine Montagedurchführung des Baugruppengehäuses hindurchgeführt ist.

Ein Ende des elektrischen Verbinders (nachfolgend als "anschlussseitiges Ende" bezeichnet) kann zur Weiterverbindung des elektrischen Verbinders mit einer weiteren elektrischen Baugruppe oder einer sonstigen elektrischen Einrichtung dienen, um elektrische Daten- und/oder Versorgungssignale auszutauschen. Hierzu ist es vorteilhaft, das anschlussseitige Ende des elektrischen Verbinders von außerhalb des Baugruppengehäuses zugänglich zu machen, beispielsweise nach außen zu führen. Es kann insbesondere vorgesehen sein, dass das anschlussseitige Ende des elektrischen Verbinders im montierten Zustand des elektrischen Verbinders, in dem der elektrische Verbinder elektrisch und mechanisch mit der elektrischen Schaltungsanordnung verbunden ist, innerhalb der Montagedurchführung oder zumindest abschnittsweise außerhalb des Baugruppengehäuses angeordnet ist.

Das anschlussseitige Ende des elektrischen Verbinders kann vorzugsweise eine Verbindungsschnittstelle, zum Beispiel eine Steckschnittstelle, zur Verbindung mit einem korrespondierendem Gegenverbinder aufweisen (es kann sich bei dem elektrischen Verbinder daher vorzugsweise um einen elektrischen Steckverbinder und bei dem elektrischen Gegenverbinder um einen elektrischen Gegensteckverbinder handeln). Es kann allerdings auch vorgesehen sein, dass das anschlussseitige Ende des elektrischen Verbinders eine Kabelzuführung bzw. einen Kabelabgang aufweist und somit unmittelbar mit einem elektrischen Kabel verbunden ist. Außerdem kann vorgesehen sein, dass das anschlussseitige Ende des elektrischen Verbinders unmittelbar mit einer weiteren elektrischen Schaltungsanordnung verbunden ist, beispielsweise mit einer elektrischen Schaltung auf einer elektrischen Leiterplatte. Grundsätzlich kann der elektrische Verbinder an dem anschlussseitigen Ende eine beliebige elektrische Anschlussmöglichkeit bereitstellen (in Sonderfällen auch eine drahtlose Anschlussmöglichkeit mittels einer Antennenanordnung).

Insbesondere wenn das anschlussseitige Ende des elektrischen Verbinders nicht aus der Montagedurchführung des Baugruppengehäuses nach außen hinausragt, kann vorgesehen sein, dass die Montagedurchführung optional verschließbar ist (beispielsweise mittels eines Deckelelementes), um ein Eindringen von Feuchtigkeit oder Verschmutzung im Falle der Nichtbenutzung des elektrischen Verbinders zu verhindern.

Erfindungsgemäß ist vorgesehen, dass sich die Verbindungsschnittstelle des elektrischen Verbinders und der Anschlussbereich der elektrischen Schaltungsanordnung kraftschlüssig kontaktieren.

Dadurch, dass sich die Verbindungsschnittstelle des elektrischen Verbinders und der Anschlussbereich der elektrischen Schaltungsanordnung kraftschlüssig kontaktieren, kann eine technisch einfache Montierbarkeit des elektrischen Verbinders gewährleistet sein. Insbesondere ein im Rahmen der Montage einer elektrischen Baugruppe häufig erforderlicher Lötprozess zur Verbindung des elektrischen Verbinders mit der elektrischen Schaltungsanordnung kann unterbleiben, was eine Montierbarkeit des elektrischen Verbinders selbst bei engem Bauraum und schlechter Zugänglichkeit ermöglicht (z. B. auch eine "blinde" bzw. schwer einsehbare Montage).

Vorzugsweise ist keine stoffschlüssige Kontaktierung zwischen dem Anschlussbereich der elektrischen Schaltungsanordnung und der Verbindungsschnittstelle des elektrischen Verbinders vorgesehen. Insbesondere ist vorzugsweise keine Lötverbindung und/oder Schweißverbindung zwischen der Verbindungsschnittstelle und dem Anschlussbereich vorgesehen.

Optional kann zusätzlich zu der kraftschlüssigen Kontaktierung der Verbindungsschnittstelle mit dem Anschlussbereich noch eine formschlüssige Verbindung vorgesehen sein, entweder durch die Verbindungsschnittstelle und den Anschlussbereich selbst oder durch zusätzliche Maßnahmen bzw. Verbindungsmittel des elektrischen Verbinders und der elektrischen Schaltungsanordnung, wie beispielsweise Rast- und Schnapphaken.

Vorzugsweise kontaktieren sich die Verbindungsschnittstelle des elektrischen Verbinders und der Anschlussbereich der elektrischen Schaltungsanordnung derart, dass die Verbindung bedarfsweise zerstörungsfrei lösbar ist. Vorzugsweise ist keine dauerhafte, untrennbare Verbindung zwischen dem elektrischen Verbinder und der elektrischen Schaltungsanordnung vorgesehen.

In einer vorteilhaften Weiterbildung der Erfindung kann vorgesehen sein, dass sich die Verbindungsschnittstelle des elektrischen Verbinders und der Anschlussbereich der elektrischen Schaltungsanordnung lateral bzw. seitlich kontaktieren.

Die Angabe "lateral" bzw. "seitlich" bezieht sich damit insbesondere auf eine Längserstreckungsrichtung des elektrischen Verbinders entlang einer Längsachse und/oder auf eine Montagerichtung des elektrischen Verbinders.

Die Kontaktierungsrichtung bzw. ein Kraftvektor der Kontaktierung von Kontaktelementen der Verbindungsschnittstelle und korrespondierenden Kontaktelementen des Anschlussbereiches verläuft somit vorzugsweise winklig zu der Längsachse des elektrischen Verbinders bzw. zu dessen Montagerichtung, vorzugsweise orthogonal oder zumindest im Wesentlichen orthogonal. Somit kann der elektrische Verbinder im Rahmen der Montage auf die elektrische Schaltungsanordnung längsseits aufgeschoben werden bzw. im Rahmen der Montage seitlich an der elektrischen Baugruppe entlanggleiten, bis der Endmontagezustand erreicht ist.

Es kann grundsätzlich aber auch vorgesehen sein, dass sich die Verbindungsschnittstelle des elektrischen Verbinders und der Anschlussbereich der elektrischen Schaltungsanordnung (bzw. deren Kontaktelemente) stirnseitig kontaktieren. Es kann also auch eine Stirnkontaktierung zwischen dem elektrischen Verbinder und der elektrischen Leiterplatte vorgesehen sein (alternativ oder zusätzlich zu der lateralen Kontaktierung). Auch die stirnseitige Kontaktierung kann im Rahmen des erfinderischen Grundgedankens kraftschlüssig erfolgen, vorzugsweise einzig kraftschlüssig.

Gemäß einer Weiterbildung der Erfindung kann vorgesehen sein, dass der Anschlussbereich der elektrischen Schaltungsanordnung zumindest abschnittsweise in der Verbindungsschnittstelle aufgenommen ist.

Der elektrische Verbinder kann im Bereich der Verbindungsschnittstelle vorteilhaft auf die elektrische Schaltungsanordnung aufgesteckt sein bzw. die elektrische Schaltungsanordnung kann abschnittsweise in den elektrischen Verbinder eingesteckt sein. Der elektrische Verbinder kann eine hierfür geeignete Aufnahme aufweisen.

Besonders bevorzugt weist der elektrische Verbinder einen Aufnahmeschlitz für die elektrischen Schaltungsanordnung auf, vorzugsweise zumindest im Bereich der Verbindungsschnittstelle, in den der Anschlussbereich der Schaltungsanordnung eingefügt werden kann. Diese Ausgestaltung hat sich als besonders geeignet herausgestellt, wenn die elektrische Schaltungsanordnung eine elektrische Schaltung aufweist, die auf einer elektrischen Trägerplatte, wie einer elektrischen Leiterplatte, angeordnet ist, da die Trägerplatte bzw. die elektrische Leiterplatte in diesem Fall mit einer Seite in den Aufnahmeschlitz des elektrischen Verbinders eingefügt werden kann.

Die Aufnahme für die Schaltungsanordnung muss allerdings nicht unbedingt als Aufnahmeschlitz ausgebildet sein. Auch eine Bohrung oder dergleichen können sich gegebenenfalls zur abschnittsweisen Aufnahme der elektrischen Schaltungsanordnung eignen. Der elektrische Verbinder kann im Bereich der Verbindungsschnittstelle beispielsweise abschnittsweise hülsenförmig ausgebildet sein.

Gemäß einer Weiterbildung der Erfindung kann vorgesehen sein, dass sich der Anschlussbereich der elektrischen Schaltungsanordnung auf zwei gegenüberliegende Hauptflächen der elektrischen Schaltungsanordnung verteilt, die jeweils von der Verbindungsschnittstelle kontaktiert werden.

Eine beidseitige Kontaktierung ermöglicht eine hohe Kontaktdichte und eignet sich außerdem vorteilhaft zur Verwendung mit einer auf einer Trägerplatte, wie einer elektrischen Leiterplatte, angeordneten elektrischen Schaltung, da in diesem Fall häufig eine beidseitige Kontaktierungsmöglichkeit besteht. Es kann grundsätzlich allerdings auch vorgesehen sein, dass zwischen dem elektrischen Verbinder und der elektrischen Schaltungsanordnung nur eine einseitige Kontaktierung vorgesehen ist.

In einer Ausgestaltung der Erfindung kann vorgesehen sein, dass die Verbindungsschnittstelle für die Verbindung mit dem Anschlussbereich wenigstens ein Kontaktelement aufweist, das vorzugsweise gefedert ausgebildet ist. Das (gefederte) Kontaktelement kann ausgebildet sein, ein korrespondierendes Kontaktelement des Anschlussbereichs, insbesondere eine Kontaktstelle des Anschlussbereichs, zu kontaktieren. Es kann alternativ oder zusätzlich auch vorgesehen sein, dass der Anschlussbereich ein gefedertes Kontaktelement aufweist. Insbesondere kann einer der Verbindungspartner oder können beide Verbindungspartner gefederte bzw. zumindest abschnittsweise elastische Kontaktelemente aufweisen.

Grundsätzlich kann das Kontaktelement der Verbindungsschnittstelle oder des Anschlussbereichs beliebig ausgebildet sein. Besonders bevorzugt sind allerdings Federkontaktstifte oder ein- oder beidseitig angebundene Kontaktfederlaschen vorgesehen (zumindest bei einem der beiden Verbindungspartner).

In einer besonders bevorzugten Weiterbildung der Erfindung kann vorgesehen sein, dass die Verbindungsschnittstelle für die Verbindung mit dem Anschlussbereich wenigstens eine Kontaktfederlasche aufweist, die eine zugeordnete Kontaktstelle des Anschlussbereichs kontaktiert.

Bei der Kontaktstelle des Anschlussbereichs kann es sich vorzugsweise um eine elektrische Leiterbahn oder um eine Kontaktfläche ("Kontaktpad") einer elektrischen Leiterplatte oder einer sonstigen Trägerplatte der elektrischen Schaltungsanordnung handeln.

Insbesondere die Kombination von Kontaktfederlaschen des elektrischen Verbinders einerseits und Kontaktstellen des Anschlussbereichs andererseits hat sich als besonders geeignet herausgestellt, um den elektrischen Verbinder im Rahmen der Montage einfach mit der elektrischen Schaltungsanordnung zu verbinden.

In einer Weiterbildung der Erfindung kann vorgesehen sein, dass das Baugruppengehäuse ein einstückiges Bauteil ist.

Bei dem Baugruppengehäuse kann es sich vorzugsweise um ein hülsenförmiges oder um ein einseitig oder beidseitig geöffnetes Bauteil handeln. Vorzugsweise ist ein Außenmantel des Baugruppengehäuses zumindest im Wesentlichen vollständig geschlossen (insbesondere abgesehen von der oder den Montagedurchführungen oder sonstigen kleineren Öffnungen, wie beispielsweise Belüftungsschlitzen, Sichtöffnungen etc.). Besagter Außenmantel des Baugruppengehäuses kann eine der Geometrie des Baugruppengehäuses entsprechende Anzahl Seitenflächen aufweisen, beispielsweise eine einzige, umlaufende Seitenfläche (im Falle eines Baugruppengehäuses mit rundem oder elliptischem Querschnitt) oder vier Seitenflächen (im Falle eines rechteckigen Querschnitts). Grundsätzlich kann der Außenmantel des Baugruppengehäuses einen beliebigen Querschnitt und eine beliebige Anzahl (zusammenhängender) Seitenflächen aufweisen.

Das Baugruppengehäuse kann von einem oder von zwei Deckelelementen vollständig verschließbar sein. Das Deckelelement kann optional von einem Anwender im Betrieb der elektrischen Baugruppe zu öffnen sein oder kann das Baugruppengehäuse nach der Montage dauerhaft verschließen. Bei dem Deckelelement kann es sich beispielsweise auch um ein elektronisches Bauteil handeln, wie eine elektrische Anzeige- und/oder Eingabevorrichtung. Zum Beispiel kann es sich bei dem Deckelelement um ein elektrisches Display handeln.

Es kann vorgesehen sein, dass das Baugruppengehäuse ein elektrisch leitfähiges Bauteil ist, insbesondere ein metallisches Bauteil.

Auf diese Weise kann vorteilhaft eine elektromagnetische Abschirmung der elektrischen Schaltungsanordnung bereitgestellt werden. Je nach Anwendung kann es sich bei dem Baugruppengehäuse grundsätzlich aber auch um ein elektrisch isolierendes Bauteil handeln, also beispielsweise um ein Kunststoffgehäuse.

In einer vorteilhaften Weiterbildung der Erfindung kann vorgesehen sein, dass die Montagedurchführung in einer geschlossenen Seitenfläche des Baugruppengehäuses ausgebildet ist. Die Montagedurchführung ist vorzugsweise in der Art eines Fensters ausgebildet.

Vorzugsweise ist die Montagedurchführung somit also nicht an einer Verbindungsstelle zweier Gehäusebauteile eines mehrteiligen Baugruppengehäuses vorgesehen. Die elektromagnetische Abschirmung, Dichtigkeit und mechanische Robustheit der elektrischen Baugruppe kann daher verbessern sein.

Die Montagedurchführung kann eine beliebige Geometrie aufweisen. Die Montagedurchführung kann beispielsweise zumindest im Wesentlichen rund oder rechteckig ausgebildet sein. Grundsätzlich kann ein beliebiger polygonaler Querschnitt vorgesehen sein.

Die Montagedurchführung kann insbesondere auch ausgebildet sein, um eine Verdrehsicherung für den montierten elektrischen Verbinder und/oder eine definierte Montageausrichtung vorzugeben.

Die Montagedurchführung kann optional eine oder mehrere Stufen bzw. Querschnittsverjüngungen aufweisen. Der Verlauf der Montagedurchführung durch das Baugruppengehäuse kann allerdings auch glatt sein.

In einer Weiterbildung der Erfindung kann vorgesehen sein, dass der elektrische Verbinder an dem Baugruppengehäuse fixiert ist.

Der elektrische Verbinder kann auf beliebige Weise an dem Baugruppengehäuse fixiert sein, insbesondere stoffschlüssig (bevorzugt), beispielsweise durch Verschweißen, Verlöten oder Verkleben des elektrischen Verbinders an dem Baugruppengehäuse (insbesondere des nachfolgend noch genannten Außenleiterkontaktelements des elektrischen Verbinders) und/oder formschlüssig (z. B. mittels Rastelementen, wie Rasthaken) und/oder kraftschlüssig (beispielsweise durch Einpressen des elektrischen Verbinders in der Montagedurchführung). Auch ein Einschrauben des elektrischen Verbinders in die Montagedurchführung kann grundsätzlich vorgesehen sein, beispielsweise wenn die Montagedurchführung ein Innengewinde und der elektrische Verbinder, beispielsweise ein Außenleiterkontaktelement des elektrischen Verbinders, ein korrespondierendes Außengewinde aufweist. Alternativ kann auch vorgesehen sein, dass einzig der elektrische Verbinder ein Außengewinde aufweist, wobei eine Fixierung an dem Baugruppengehäuse durch innenseitig und/oder außenseitig der Montagedurchführung angeordnete Überwurfmuttern erfolgt.

Vorzugsweise ist eine verdrehsichere Fixierung des elektrischen Verbinders an dem Baugruppengehäuse vorgesehen, so dass Querkräfte und Drehmomente, die auf das anschlussseitige Ende des elektrischen Verbinders wirken, über das Baugruppengehäuse vorteilhaft abgeleitet werden und die elektrische Schaltungsanordnung bzw. die Verbindung des elektrischen Verbinders mit der Schaltungsanordnung nicht beschädigt.

In einer vorteilhaften Weiterbildung der Erfindung kann vorgesehen sein, dass der elektrische Verbinder und die Montagedurchführung des Baugruppengehäuses so ausgebildet sind, dass der elektrische Verbinder von außerhalb des Baugruppengehäuses mit einem verbindungsschnittstellenseitigen Ende in die Montagedurchführung bis in einen Endmontagezustand einführbar ist, in dem die Verbindungsschnittstelle mit der elektrischen Schaltungsanordnung verbunden ist.

Auf vorteilhafte Weise kann der elektrische Verbinder somit vollständig von außerhalb des Baugruppengehäuses in das Baugruppengehäuse eingeführt werden, bis er die elektrische Schaltungsanordnung im Endmontagezustand kontaktiert. Die elektrische Schaltungsanordnung kann daher bereits in dem Baugruppengehäuse vormontiert sein, was eine besonders kompakte Bauweise des Baugruppengehäuses ermöglicht. Das Baugruppengehäuse kann in diesem Vormontagezustand gegebenenfalls auch bereits vollständig geschlossen sein.

Die Montagedurchführung kann vorteilhaft eine Führung für die Montagebewegung des elektrischen Verbinders bereitstellen, was die Montage für einen Monteur weiter vereinfacht sowie Montagefehler und Beschädigungen der elektrischen Schaltungsanordnung während der Montage verhindern kann.

In einer vorteilhaften Weiterbildung der Erfindung kann vorgesehen sein, dass der elektrische Verbinder und die elektrische Schaltungsanordnung eine gegenseitige mechanische Kodierung ausbilden, um eine definierte gegenseitige Ausrichtung vorzugeben und/oder um eine Verdrehsicherung auszubilden.

Der elektrische Verbinder kann beispielsweise in der Verbindungsschnittstelle, gegebenenfalls aber auch außerhalb der Verbindungsschnittstelle, eines oder mehrere mechanische Kodierungsmittel aufweisen. Bei dem mechanischen Kodierungsmittel kann es sich vorzugsweise um einen Vorsprung handeln, wie einen Kodierungssteg, einen Kodierungsstift oder eine Kodierungsrippe. Die spezifische Ausgestaltung des Kodierungsmittels ist für die Erfindung allerdings nicht einschränkend. Die elektrische Schaltungsanordnung, insbesondere eine Trägerplatte bzw. eine elektrische Leiterplatte, auf der die elektrische Schaltung angeordnet ist, kann vorzugsweise ein mechanisches Gegenkodierungsmittel aufweisen, insbesondere (aber nicht ausschließlich) einen Rücksprung oder eine Ausnehmung, wie beispielsweise einen in Montagerichtung des elektrischen Verbinders verlaufenden Längsschlitz.

Insofern das mechanische Kodierungsmittel und das mechanische Gegenkodierungsmittel außermittig angeordnet sind, kann einerseits eine definierte gegenseitigen Ausrichtung vorgegeben und außerdem eine Verdrehsicherung bereitgestellt oder verbessert werden.

Eine Verdrehsicherung kann auch bereits durch eine formschlüssige Verbindung zwischen dem elektrischen Verbinder und der elektrischen Schaltungsanordnung bereitgestellt werden. Insbesondere kann der elektrische Verbinder seitlich passgenau auf die Schaltungsanordnung aufgeschoben sein (die Schaltungsanordnung kann z. B. in dem vorstehend bereits genannten Aufnahmeschlitz des elektrischen Verbinders aufgenommen sein), wobei eine jeweilige Auflagefläche des elektrischen Verbinders (z. B. des nachfolgend noch genannten Kontaktelementträgers) eine korrespondierende Gegenfläche der elektrischen Schaltungsanordnung, insbesondere die Hauptflächen einer Trägerplatte bzw. elektrischen Leiterplatte, unmittelbar kontaktiert. Auf diese Weise verhindert bereits das seitliche Montieren des elektrischen Verbinders auf der elektrische Schaltungsanordnung ein Verdrehen, so dass keine weiteren Maßnahmen erforderlich sind.

Es kann vorzugsweise ein axialer Endanschlag für die Montage des elektrischen Verbinders auf der Schaltungsanordnung vorgesehen sein. Der Endanschlag kann insbesondere zwischen dem elektrischen Verbinder und dem Baugruppengehäuse und/oder zwischen dem elektrischen Verbinder und der Schaltungsanordnung ausgebildet sein. Ein Endanschlag kann beispielsweise bereits durch einen Flanschabschnitt des anschlussseitigen Endes des elektrischen Verbinders und/oder durch die Länge des vorstehend genannten Aufnahmeschlitzes ausgebildet sein.

In einer vorteilhaften Weiterbildung der Erfindung kann vorgesehen sein, dass der elektrische Verbinder ein Außenleiterkontaktelement aufweist.

Bei dem Außenleiterkontaktelement kann es sich insbesondere um ein hülsenförmiges Außenleiterkontaktelement handeln, das die weiteren Komponenten des elektrischen Verbinders zumindest im Wesentlichen umhüllt. Bei dem Außenleiterkontaktelement kann es sich vorzugsweise gleichzeitig um das Außengehäuse des elektrischen Verbinders handeln.

Das Außenleiterkontaktelement des elektrischen Verbinders kann vorzugsweise unmittelbar mit der Montagedurchführung verbunden sein bzw. die Montagedurchführung unmittelbar innenseitig kontaktieren.

Insbesondere die mechanische Fixierung zwischen der Montagedurchführung und dem elektrischen Verbinder kann über das Außenleiterkontaktelement erfolgen.

Das Außenleiterkontaktelement kann einen Flanschabschnitt aufweisen, mit dem es sich an dem Baugruppengehäuse außenseitige abzustützen vermag. Insofern die Montagedurchführung gestuft ausgebildet ist, kann das Außenleiterkontaktelement entsprechend komplementär ausgestaltet sein, um vorzugsweise passgenau in der Montagedurchführung montierbar zu sein.

In einer Weiterbildung der Erfindung kann vorgesehen sein, dass der elektrische Verbinder einen Kontaktelementträger aufweist, insbesondere einen elektrisch isolierenden Kontaktelementträger, beispielsweise aus einem Kunststoff.

Der Kontaktelementträger kann eine oder mehrere Kontaktaufnahmen zur Aufnahme und/oder Fixierung elektrischer Kontaktelemente des elektrischen Verbinders aufweisen. Bei den Kontaktaufnahmen kann es sich insbesondere um jeweilige Kontaktkammern oder Nuten für ein jeweiliges Kontaktelement handeln.

Vorzugsweise ist der Kontaktelementträger in dem vorstehend genannten Außenleiterkontaktelement aufgenommen und fixiert. Hierzu kann zwischen Kontaktelementträger und Außenleiterkontaktelement eine kraftschlüssige und/oder formschlüssige Verbindung vorgesehen sein, die optional außerdem eine Verdrehsicherung zwischen Außenleiterkontaktelement und Kontaktelementträger gewährleistet. Beispielsweise kann der Kontaktelementträger auf seiner Außenmantelfläche einen Montagezapfen aufweisen, der in einer korrespondierenden Montageaufnahme des Außenleiterkontaktelements aufgenommen ist - oder umgekehrt.

Der Kontaktelementträger kann vorzugsweise ausgebildet sein, die Kontaktelemente des elektrischen Verbinders, insbesondere im Bereich der Verbindungsschnittstelle, vor mechanischer Beschädigung zu schützen. Die Kontaktelemente des elektrischen Verbinders können daher insbesondere im Bereich der Verbindungsschnittstelle vorzugsweise vollständig innerhalb des Kontaktelementträgers angeordnet sein und beispielweise einzig durch den vorstehend genannten Aufnahmeschlitz für die Kontaktierung mit der Schaltungsanordnung (seitlich) zugänglich sein.

In einer Weiterbildung der Erfindung kann vorgesehen sein, dass der elektrische Verbinder ein Schirmelement aufweist, das mit dem Außenleiterkontaktelement einerseits und mit der elektrischen Schaltungsanordnung andererseits elektrisch und mechanisch verbunden ist. Das Schirmelement ist also vorzugsweise zwischen dem Außenleiterkontaktelement und dem Kontaktelementträger angeordnet.

Vorzugsweise umhüllt das Schirmelement den Kontaktelementträger zumindest abschnittsweise, vorzugsweise hülsenförmig.

Die Außenleiteranbindung des elektrischen Verbinders an einen Außenleiter der elektrischen Schaltungsanordnung kann also über das separate Schirmelement erfolgen. Grundsätzlich kann die Außenleiteranbindung allerdings auch unmittelbar durch Verbindung des Außenleiterkontaktelements des elektrischen Verbinders mit der elektrischen Schaltungsanordnung erfolgen.

Bei dem Schirmelement handelt es sich vorzugsweise um ein Stanz-Biegeteil.

Das Schirmelement kann wenigstens eine erste elektrische Kontaktlasche, vorzugsweise eine Gruppe mehrerer erster elektrischer Kontaktlaschen, aufweisen, die mit dem Außenleiterkontaktelement kraftschlüssig verbunden sind und/oder wenigstens eine zweite elektrische Kontaktlasche, vorzugsweise eine Gruppe mehrerer zweiter elektrischer Kontaktlaschen, die mit der elektrischen Schaltungsanordnung kraftschlüssig verbunden sind, insbesondere mit korrespondierenden Kontaktstellen der elektrischen Schaltungsanordnung, insbesondere in dem Anschlussbereich. Die erste(n) und/oder zweite(n) Kontaktlaschen bzw. eine oder beide der genannten Gruppen von Kontaktlaschen können grundsätzlich allerdings auch entfallen, wenn die Verbindung mit Außenleiterkontaktelement und/oder Schaltungsanordnung auf andere Weise erfolgt, beispielsweise durch unmittelbares Verpressen der Bauteile miteinander.

Gemäß einer bevorzugten Variante kann die Kontaktierung des Schirmelementes mit der elektrischen Baugruppe durch eine oder mehrere Kontaktklammern erfolgen, die seitlich in Verlängerung des Aufnahmeschlitzes angeordnet sind (vorzugsweise beidseits des Aufnahmeschlitzes). Eine Kontaktklammer kann dabei insbesondere aus zwei gegenüberliegenden zweiten Kontaktlaschen gebildet sein.

Gemäß einer Weiterbildung der Erfindung kann vorgesehen sein, dass die elektrische Schaltungsanordnung eine Trägerplatte, insbesondere eine elektrische Leiterplatte, und eine auf der Trägerplatte realisierte elektrische Schaltung aufweist.

Wie bereits erwähnt, eignet sich die Erfindung besonders vorteilhaft zur Verwendung mit einer eine elektrische Leiterplatte aufweisenden elektrischen Schaltungsanordnung, da der elektrische Verbinder dann vorteilhaft von der Seite auf die Leiterplatte aufgeschoben werden kann, insbesondere wenn der elektrische Verbinder einen geeigneten Aufnahmeschlitz für die elektrische Leiterplatte aufweist.

In einer vorteilhaften Weiterbildung der Erfindung kann vorgesehen sein, dass sich das wenigstens eine Kontaktelement des elektrischen Verbinders entlang einer Längserstreckung des elektrischen Verbinders bis in die Verbindungsschnittstelle erstreckt und die elektrische Schaltungsanordnung in dem Anschlussbereich unmittelbar kontaktiert.

Vorzugsweise ist das wenigstens eine Kontaktelement einstückig ausgebildet, beispielsweise als Stanz-Biegeteil.

Das elektrische Kontaktelement kann an dem anschlussseitigen Ende des elektrischen Verbinders zur Weiterverbindung mit beispielsweise elektrischen Leitern eines elektrischen Kabels, zur unmittelbaren Kontaktierung eines Anschlussbereichs einer weiteren elektrischen Schaltungsanordnung oder zur Kontaktierung korrespondierender Gegenkontaktelemente eines Gegensteckverbinders ausgebildet sein.

Grundsätzlich eignet sich die Erfindung zur Verwendung mit einem elektrischen Verbinder mit einer beliebigen Anzahl elektrischer Kontaktelemente. Der elektrische Verbinder kann beispielsweise genau ein elektrisches Kontaktelement, zwei, drei, vier, fünf, sechs, sieben, acht oder noch mehr elektrische Kontaktelemente aufweisen.

Im Rahmen der Erfindung sind grundsätzlich alle Signalisierungs- und/oder Stromversorgungsverbindungen möglich. Beispielsweise kann der elektrische Verbinder zur Übertragung eines asymmetrischen Signals, eines symmetrischen Signals, für eine geschirmte oder nicht geschirmte Übertragung, für eine Gleichstromübertragung, für eine ein- oder mehrphasige Wechselstromübertragung etc. vorgesehen sein. Der elektrische Verbinder kann sich vorteilhaft eignen, beliebige Strom- und/oder Datensignale (z. B. für eine Sensorsignalverarbeitung) an die elektrische Baugruppe zuzuführen und/oder von der elektrischen Baugruppe abzuführen.

Der elektrische Verbinder eignet sich grundsätzlich für beliebige Anwendungen innerhalb der gesamten Elektrotechnik und kann daher grundsätzlich beliebig ausgebildet sein. Insbesondere kann ein etwaiges Anschlussinterface im Bereich des anschlussseitigen Endes des elektrischen Verbinders allerdings als Steckschnittstelle zur Verbindung mit einem korrespondierenden Gegensteckverbinder ausgebildet sein.

Das Anschlussinterface bzw. das anschlussseitige Ende des elektrischen Verbinders kann vorzugsweise zumindest im Wesentlichen rund ausgebildet sein. Es kann sich also beispielsweise um einen in dem Baugruppengehäuse optional fixierbaren Rundsteckverbinder handeln, beispielsweise um einen M8-, M12- oder M23-Rundsteckverbinder. Die Erfindung eignet sich besonders vorteilhaft zur Verwendung mit Rundsteckverbindern, ist aber nicht auf diese Geometrie beschränkt zu verstehen.

Bei der elektrischen Baugruppe kann es sich im Rahmen der Erfindung um eine beliebige elektrische Baugruppe handeln, die für einen beliebigen Einsatzzweck eingerichtet ist. Besonders vorteilhaft kann es sich bei der elektrischen Baugruppe allerdings um eine Sensorbaugruppe handeln, beispielsweis um eine Sensorsignalverarbeitung für einen in der elektrischen Baugruppe integrierten oder separaten Sensor (z. B. einen Ultraschallsensor).

Die Erfindung betrifft auch ein Verfahren zur Montage einer elektrischen Baugruppe, aufweisend zumindest die folgenden Verfahrensschritte:
- Bereitstellen eines Baugruppengehäuses und einer in dem Baugruppengehäuse aufgenommenen elektrischen Schaltungsanordnung;
- Bereitstellen eines elektrischen Verbinders, der eine Verbindungsschnittstelle zur Verbindung mit der elektrischen Schaltungsanordnung aufweist; und
- Hindurchführen des elektrischen Verbinders durch eine Montagedurchführung des Baugruppengehäuses, bis die Verbindungsschnittstelle elektrisch und mechanisch mit einem korrespondierenden Anschlussbereich der elektrischen Schaltungsanordnung verbunden ist.

Erfindungsgemäß ist für das Verfahren vorgesehen, dass sich die Verbindungsschnittstelle des elektrischen Verbinders und der Anschlussbereich der elektrischen Schaltungsanordnung in dem montierten Zustand kraftschlüssig kontaktieren.

Auf vorteilhafte Weise kann somit insbesondere auf einen Lötprozess im Rahmen der Montage verzichtet werden, was den Aufwand für den Monteur und die Fehleranfälligkeit im Rahmen der Endmontage deutlich verringern kann.

Die Erfindung betrifft außerdem auch einen elektrischen Verbinder für eine elektrische Baugruppe, der eine Verbindungsschnittstelle aufweist, die elektrisch und mechanisch mit einem korrespondierenden Anschlussbereich einer elektrischen Schaltungsanordnung der elektrischen Baugruppe verbindbar ist, wobei der elektrische Verbinder durch eine Montagedurchführung eines Baugruppengehäuses der elektrischen Baugruppe hindurchführbar ist. Der elektrische Verbinder kennzeichnet sich dadurch, dass die Verbindungsschnittstelle den Anschlussbereich der elektrischen Schaltungsanordnung kraftschlüssig zu kontaktieren vermag und/oder von dem Anschlussbereich der elektrischen Schaltungsanordnung kraftschlüssig kontaktierbar ist. Die Anmelderin behält sich vor, den elektrischen Verbinder separat von der in Patentanspruch 1 definierten elektrischen Baugruppe zu beanspruchen. Gleichermaßen behält sich die Anmelderin vor, das Baugruppengehäuse und/oder die elektrische Schaltungsanordnung separat zu beanspruchen.

Merkmale, die im Zusammenhang mit einem der Gegenstände der Erfindung, namentlich gegeben insbesondere durch die erfindungsgemäße elektrische Baugruppe, den elektrischen Verbinder oder das erfindungsgemäße Verfahren, beschrieben wurden, sind auch für die anderen Gegenstände der Erfindung vorteilhaft umsetzbar. Ebenso können Vorteile, die im Zusammenhang mit einem der Gegenstände der Erfindung genannt wurden, auch auf die anderen Gegenstände der Erfindung bezogen verstanden werden.

Ergänzend sei darauf hingewiesen, dass Begriffe wie "umfassend", "aufweisend" oder "mit" keine anderen Merkmale oder Schritte ausschließen. Ferner schließen Begriffe wie "ein" oder "das", die auf eine Einzahl von Schritten oder Merkmalen hinweisen, keine Mehrzahl von Merkmalen oder Schritten aus - und umgekehrt.

In einer puristischen Ausführungsform der Erfindung kann allerdings auch vorgesehen sein, dass die in der Erfindung mit den Begriffen "umfassend", "aufweisend" oder "mit" eingeführten Merkmale abschließend aufgezählt sind. Dementsprechend kann eine oder können mehrere Aufzählungen von Merkmalen im Rahmen der Erfindung als abgeschlossen betrachtet werden, beispielsweise jeweils für jeden Anspruch betrachtet. Die Erfindung kann beispielsweise ausschließlich aus den in Anspruch 1 genannten Merkmalen bestehen.

Es sei erwähnt, dass Bezeichnungen wie "erstes" oder "zweites" etc. vornehmlich aus Gründen der Unterscheidbarkeit von jeweiligen Vorrichtungs- oder Verfahrensmerkmalen verwendet werden und nicht unbedingt andeuten sollen, dass sich Merkmale gegenseitig bedingen oder miteinander in Beziehung stehen.

Ferner sei betont, dass die vorliegend beschriebenen Werte und Parameter Abweichungen oder Schwankungen von ±10% oder weniger, vorzugsweise ±5% oder weniger, weiter bevorzugt ±1% oder weniger, und ganz besonders bevorzugt ±0,1% oder weniger des jeweils benannten Wertes bzw. Parameters mit einschließen, sofern diese Abweichungen bei der Umsetzung der Erfindung in der Praxis nicht ausgeschlossen sind. Die Angabe von Bereichen durch Anfangs- und Endwerte umfasst auch all diejenigen Werte und Bruchteile, die von dem jeweils benannten Bereich eingeschlossen sind, insbesondere die Anfangs- und Endwerte und einen jeweiligen Mittelwert.

Nachfolgend werden Ausführungsbeispiele der Erfindung anhand der Zeichnungen näher beschrieben.

Die Figuren zeigen jeweils bevorzugte Ausführungsbeispiele, in denen einzelne Merkmale der vorliegenden Erfindung in Kombination miteinander dargestellt sind. Merkmale eines Ausführungsbeispiels sind auch losgelöst von den anderen Merkmalen des gleichen Ausführungsbeispiels umsetzbar und können dementsprechend von einem Fachmann ohne Weiteres zu weiteren sinnvollen Kombinationen und Unterkombinationen mit Merkmalen anderer Ausführungsbeispiele verbunden werden.

In den Figuren sind funktionsgleiche Elemente mit denselben Bezugszeichen versehen.

Es zeigen schematisch:
- Figur 1: ein Baugruppengehäuse und eine in dem Baugruppengehäuse vormontierte elektrische Schaltungsanordnung einer elektrischen Baugruppe gemäß einem Ausführungsbeispiel der Erfindung, in einer perspektivischen Darstellung;
- Figur 2: die elektrische Baugruppe gemäß Figur 1 mit einem in dem Baugruppengehäuse montierten und mit der elektrischen Baugruppe verbundenen elektrischen Verbinder, in einer perspektivischen Darstellung;
- Figur 3: die elektrische Baugruppe mit dem montierten elektrischen Verbinder gemäß Figur 2, in einer seitlichen Schnittdarstellung;
- Figur 4: den elektrischen Verbinder der Figuren 2 und 3 in einer perspektivischen Einzeldarstellung;
- Figur 5: den elektrischen Verbinder der Figur 4 in einer Seitenansicht;
- Figur 6: den elektrischen Verbinder der Figur 4 in einer Vorderansicht der Verbindungsschnittstelle;
- Figur 7: den elektrischen Verbinder der Figur 4 in einer seitlichen Schnittdarstellung entlang der Schnittlinie VII-VII der Figur 6;
- Figur 8: den elektrischen Verbinder der Figur 4 in einer perspektivischen Darstellung ohne das Außenleiterkontaktelement;
- Figur 9: das Schirmelement des elektrischen Verbinders der Figur 4 in einer perspektivischen Einzeldarstellung;
- Figur 10: ein einzelnes elektrisches Kontaktelement des elektrischen Verbinders der Figur 4 in einer perspektivischen Darstellung; und
- Figur 11: eine Ausschnittsvergrößerung der elektrischen Schaltungsanordnung zur Darstellung des Anschlussbereiches.

Die Figuren zeigen beispielhaft ein Ausführungsbeispiel der Erfindung, das nicht einschränkend zu verstehen ist. Das Ausführungsbeispiel wird nachfolgend figurenübergreifend beschrieben.

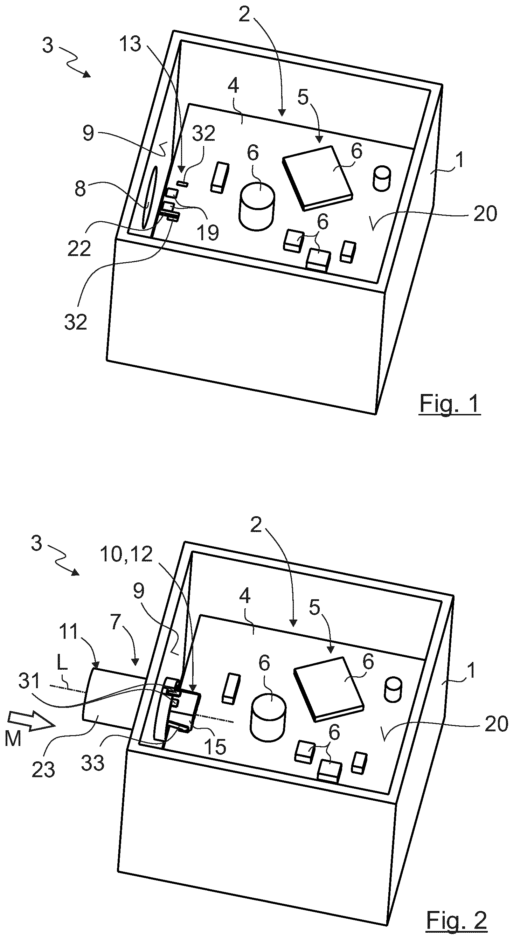

Die Figuren 1 bis 3 zeigen beispielhaft ein Baugruppengehäuse 1 und eine in dem Baugruppengehäuse 1 aufgenommene elektrische Schaltungsanordnung 2 einer elektrischen Baugruppe 3. Die elektrische Schaltungsanordnung 2 weist beispielhaft eine elektrische Leiterplatte 4 auf, auf der eine elektrische Schaltung 5 ausgebildet ist. Exemplarisch sind in den Figu-ren 1 bis 3 einige elektronische Bauteile 6 angedeutet, bei denen es sich u. a. um Widerstände, Spulen, Kondensatoren und integrierte Schaltkreise handeln kann.

Das Baugruppengehäuse 1 ist beispielhaft ein einstückiges, hülsenförmiges, metallisches Bauteil. Optional können geeignete Deckelelemente vorgesehen sein (nicht dargestellt), um die elektrische Schaltungsanordnung 2 vorzugsweise vollständig einzuschließen. Bei besagten Deckelelementen kann es sich gegebenenfalls auch um elektrische Anzeige- und/oder Eingabevorrichtungen handeln.

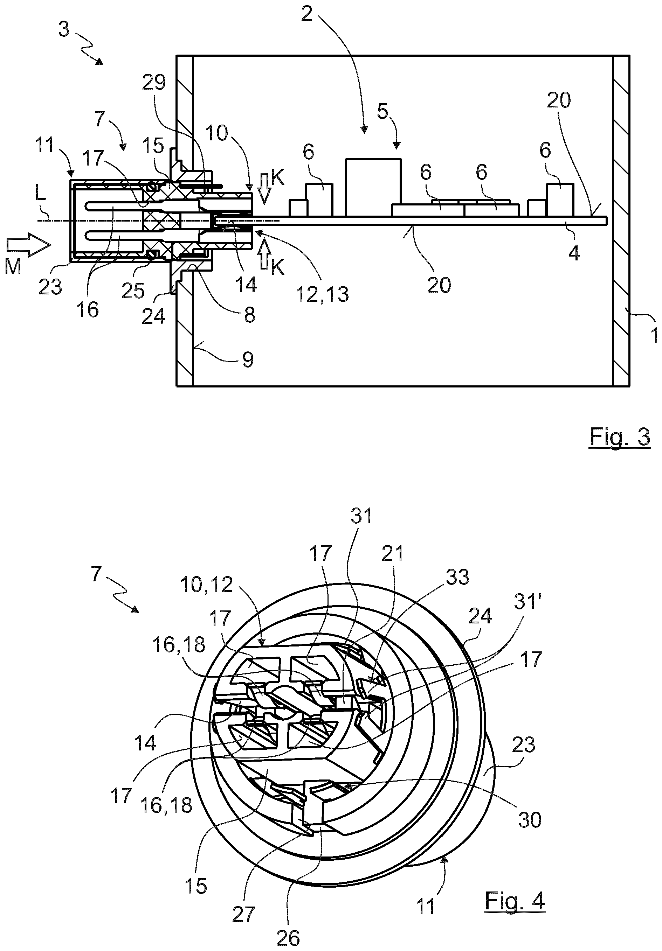

Die elektrische Schaltungsanordnung 2 ist innerhalb des Baugruppengehäuses 1 aufgenommen und fixiert. Insbesondere kann im Rahmen eines Verfahrens zur Montage der elektrischen Baugruppe 3 vorgesehen sein, dass die elektrische Schaltungsanordnung 2, also insbesondere die elektrische Leiterplatte 4 mit der darauf realisierten elektrischen Schaltung 5, in dem Baugruppengehäuse 1 bereits vormontiert ist, wie in Figur 1 dargestellt. Im Rahmen der weiteren Montage kann dann vorgesehen sein, dass ein elektrischer Verbinder 7 durch eine Montagedurchführung 8 des Baugruppengehäuses 1 bis in einen Endmontagezustand (vgl. Figuren 2 und 3) hindurchgeführt wird. Der elektrische Verbinder 7 ist in den Figuren 4 bis 7 in einer jeweiligen Einzeldarstellung in verschiedenen Ansichten gezeigt.

Die Montagedurchführung 8 des Baugruppengehäuses 1 ist vorzugsweise in einer geschlossenen Seitenfläche 9 des Baugruppengehäuses 1 in der Art eines Fensters ausgebildet. Im Ausführungsbeispiel handelt es sich bei der Montagedurchführung 8 um eine gestufte, runde Bohrung (der Verlauf der Montagedurchführung 8 durch das Baugruppengehäuse 1 kann allerdings auch glatt sein). Der elektrische Verbinder 7 und die Montagedurchführung 8 des Baugruppengehäuses 1 sind dabei so ausgebildet, dass der elektrische Verbinder 7 vollständig von außerhalb des Baugruppengehäuses 1 mit einem verbindungsschnittstellenseitigen Ende 10 in die Montagedurchführung 8 bis in den Endmontagezustand entlang einer Montagerichtung M (vgl. Figur 2) einführbar ist. In dem Endmontagezustand ist der elektrische Verbinder 7 mit der elektrischen Schaltungsanordnung 2 verbunden, wie nachfolgend noch beschrieben wird.

Der elektrische Verbinder 7 weist in dem Ausführungsbeispiel außerdem ein von dem verbindungsschnittstellenseitigen Ende 10 abgewandtes, anschlussseitiges Ende 11 auf, das eine nicht näher dargestellte Anschlussmöglichkeit für einen Gegensteckverbinder bereitstellt. Vorzugsweise handelt es sich um eine Steckschnittstelle, die von außerhalb des Baugruppengehäuses 1 zugänglich ist (die also aus der Montagedurchführung 8 nach außen hinausragt, wie dargestellt). Wie vorstehend bereits erwähnt, kann das anschlussseitige Ende 11 des elektrischen Verbinders 7 allerdings auch eine direkte Anschlussmöglichkeit für ein Kabel ausbilden, so dass beispielsweise ein Kabel unmittelbar mit dem elektrischen Verbinder 7 verbunden und gemeinsam mit dem elektrischen Verbinder 7 in dem Baugruppengehäuse 1 montierbar ist.

Es sei betont, dass der elektrische Verbinder 7 mit seinem anschlussseitigen Ende 11 nicht unbedingt aus der Montagedurchführung 8 hinausragen muss, wenngleich dies in der Regel vorteilhaft sein kann.

Der elektrische Verbinder 7 kann an dem Baugruppengehäuse 1 fixiert sein, insbesondere verdrehsicher fixiert sein. Hierzu kann der elektrische Verbinder 7 insbesondere stoffschlüssig an dem Baugruppengehäuse 1 fixiert sein, beispielsweise durch eine Schweiß-, Löt- oder Klebeverbindung. Auch ein Einpressen oder eine sonstige kraftschlüssige Verbindung und/oder eine formschlüssige Verbindung können vorgesehen sein (nicht dargestellt).

Beispielhaft ist der elektrische Verbinder 7 als Rundsteckverbinder dargestellt, was eine besonders vorteilhafte Anwendung für die Erfindung darstellt, allerdings nicht einschränkend zu verstehen ist.

Der elektrische Verbinder 7 weist im Bereich des verbindungsschnittstellenseitigen Endes 10 eine Verbindungsschnittstelle 12 auf, die elektrisch und mechanisch mit einem korrespondierenden Anschlussbereich 13 der elektrischen Schaltungsanordnung 2 verbunden ist, wenn sich der elektrische Verbinder 7 in seinem Endmontagezustand befindet. Die Kontaktierung zwischen der Verbindungsschnittstelle 12 des elektrischen Verbinders 7 und dem Anschlussbereich 13 der elektrischen Schaltungsanordnung 2 erfolgt kraftschlüssig und wird nachfolgend im Detail erläutert.

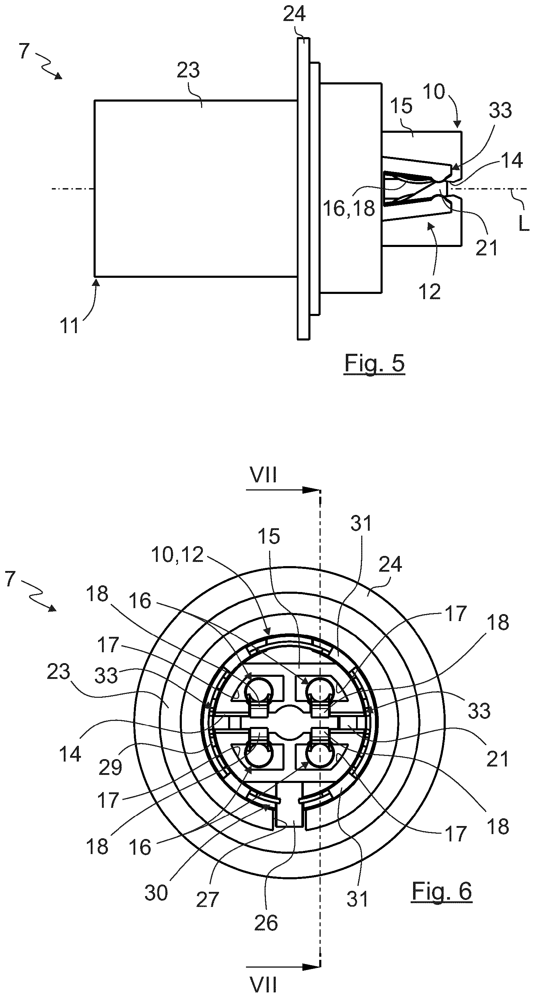

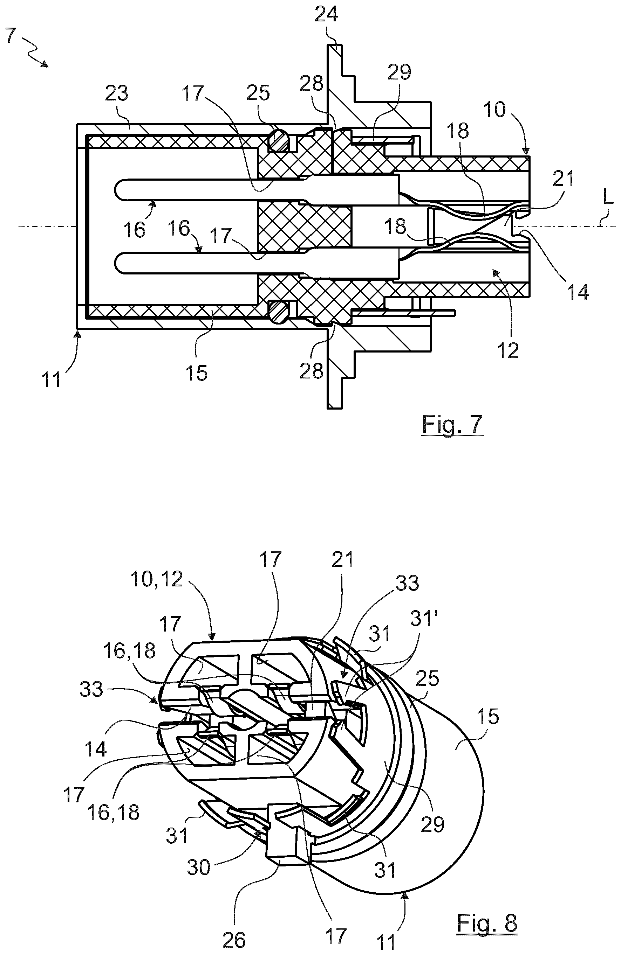

Wie sich insbesondere im Hinblick auf Figur 3 ergibt, kontaktieren sich die Verbindungsschnittstelle 12 des elektrischen Verbinders 7 und der Anschlussbereich 13 der elektrischen Schaltungsanordnung 2 lateral bzw. seitlich in Bezug auf die Längsachse L bzw. die Montagerichtung M des elektrischen Verbinders 7. Die Kontaktierungsrichtung K bzw. ein Kraftvektor der Kontaktierung ist in Figur 3 angedeutet und orthogonal zu der Montagerichtung M des elektrischen Verbinders 7 ausgerichtet. Für die Kontaktierung wird der Anschlussbereich 13 der elektrischen Schaltungsanordnung 2 in der Verbindungsschnittstelle 12 aufgenommen. Der elektrische Verbinder 7 weist einen Aufnahmeschlitz 14 für die elektrische Leiterplatte 4 auf (vgl. insbesondere die Figuren 7 und 8). Der Aufnahmeschlitz 14 ist in einem Kontaktelementträger 15 des elektrischen Verbinders 7 ausgebildet, in dem die einzelnen elektrischen Kontaktelemente 16 des elektrischen Verbinders 7 in jeweiligen Kontaktaufnahmen 17 bzw. Kontaktkammern aufgenommen sind. An dem verbindungsschnittstellenseitigen Ende 10 des elektrischen Verbinders 7 sind die Kontaktelemente 16 als jeweilige Kontaktfederlaschen 18 ausgebildet, die in die Verbindungsschnittstelle 12 hineinragen (vgl. insbesondere die Figuren 6, 7 und 10). An dem anschlussseitigen Ende 11 des elektrischen Verbinders 7 sind die Kontaktelemente 16 hingegen zur unmittelbaren Kontaktierung mit nicht dargestellten Gegenkontaktelementen eines Gegensteckverbinders ausgebildet (im Ausführungsbeispiel bilden die Kontaktelemente 16 jeweils einen Kontaktstift aus).

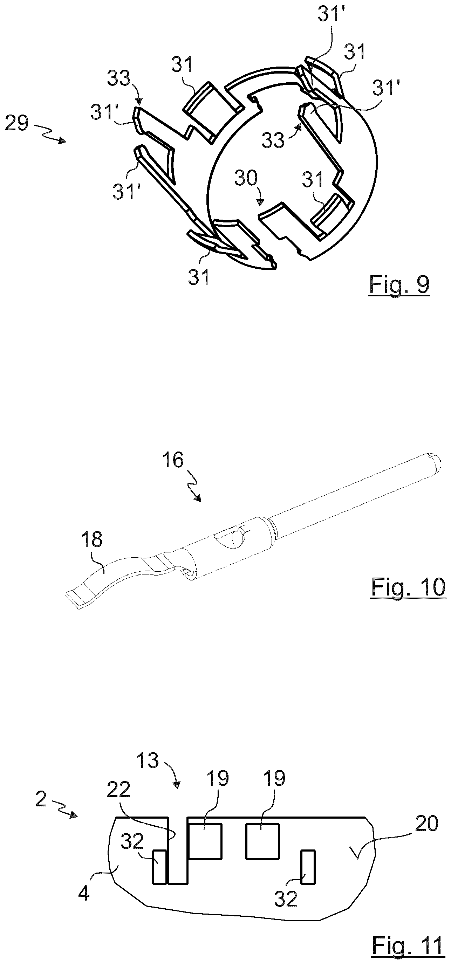

Die Kontaktfederlaschen 18 der Kontaktelemente 16 kontaktieren zugeordnete Kontaktstellen 19 des Anschlussbereichs 13, die beispielsweise in Figur 1 erkennbar und in Figur 11 in einem vergrößerten Ausschnitt dargestellt sind. Bei den Kontaktstellen 19 handelt es sich beispielhaft um Kontaktflächen bzw. Kontaktpads oder Leiterbahnen der elektrischen Leiterplatte 4.

In dem dargestellten Ausführungsbeispiel verteilt sich der Anschlussbereich 13 der elektrischen Schaltungsanordnung 2 auf die zwei gegenüberliegende Hauptflächen 20 der elektrischen Leiterplatte 4, um die Kontaktdichte zu erhöhen. Beispielhaft sind pro Hauptfläche 20 der Leiterplatte 4 zwei Kontaktelemente 16 vorgesehen.

An dieser Stelle sei erwähnt, dass als Alternative zu den dargestellten Kontaktfederlaschen 18 auch noch weitere Varianten von elastischen Kontaktelementen 16 vorgesehen sein können. So können beispielsweise auch Kontaktklammern vorgesehen sein, so dass ein einziges Kontaktelement 16 die Leiterplatte 4 beispielsweise umgreift. Auch Federkontaktstifte können vorgesehen sein. Ferner kann vorgesehen sein, dass die Elastizität für die seitliche Kontaktierung alternativ oder zusätzlich auch von der elektrischen Leiterplatte 4 bereitgestellt wird.

Der elektrische Verbinder 7 und die elektrische Schaltungsanordnung 2 bilden eine gegenseitige mechanische Kodierung aus, um eine definierte gegenseitige Ausrichtung und/oder Verdrehsicherung auszubilden. Hierfür weist der Kontaktelementträger 15 ein als Vorsprung ausgebildetes mechanisches Kodierungsmittel 21 auf, das aufgrund der außermittigen Anordnung nur bei korrekter Ausrichtung des elektrischen Verbinders 7 relativ zu der elektrischen Leiterplatte 4 in ein korrespondierendes mechanisches Gegenkodiermittel 22 (vgl. den in Figur 11 erkennbaren, in Montagerichtung M ausgerichteten Längsschlitz) einzugreifen vermag. Anderenfalls ist das vollständige Aufstecken des elektrischen Verbinders 7 auf die elektrische Leiterplatte 4 nicht möglich.

Der elektrische Verbinder 7 weist außerdem ein Außenleiterkontaktelement 23 auf, das gleichzeitig ein Außengehäuse für den elektrischen Verbinder 7 ausbildet (vgl. insbesondere die Figu-ren 4 bis 6). Das Außenleiterkontaktelement 23 weist einen Flanschabschnitt 24 auf, mit dem es sich außenseitig an dem Baugruppengehäuse 1 abzustützen vermag. Ferner ist das Außenleiterkontaktelement 23 komplementär zu der Montagedurchführung 8 ausgebildet, um ein passgenaues Einfügen des elektrischen Verbinders 7 in die Montagedurchführung 8 zu ermöglichen. Zwischen dem Außenleiterkontaktelement 23 und dem Kontaktelementträger 15 kann optional ein Dichtungselement, wie beispielsweise der in Figur 7 und 8 erkennbare Dichtring 25, angeordnet sein.

Auch zwischen dem Kontaktelementträger 15 und dem Außenleiterkontaktelement 23 kann vorzugsweise eine Verdrehsicherung bereitgestellt werden. Hierfür weist der Kontaktelementträger 15 beispielhaft einen Montagezapfen 26 und das Außenleiterkontaktelement 23 eine Montageaufnahme 27 auf, wie in Figur 4 und 6 gut erkennbar ist.

Die Fixierung zwischen Außenleiterkontaktelement 23 und Kontaktelementträger 15 kann formschlüssig, kraftschlüssig und/oder stoffschlüssig erfolgen. Beispielsweise kann das Außenleiterkontaktelement 23 innenmantelseitige Krallen 28 aufweisen, um sich in dem Kontaktelementträger 15 zu verkrallen (vgl. Figur 7).

Für eine Außenleiteranbindung zwischen dem elektrischen Verbinder 7 und der elektrischen Schaltungsanordnung 2 weist der elektrische Verbinder 7 gemäß dem dargestellten Ausführungsbeispiel ein Schirmelement 29 auf, das zwischen dem Außenleiterkontaktelement 23 und dem Kontaktelementträger 15 angeordnet ist. Um dieses besser darstellen zu können, ist in Figur 8 das Außenleiterkontaktelement 23 des elektrischen Verbinders 7 ausgeblendet und das Schirmelement 29 außerdem in Figur 9 in einer Einzeldarstellung gezeigt.

Bei dem Schirmelement 29 handelt es sich beispielhaft um ein hülsenförmig umgeformtes Kontaktblech, das auf dem Kontaktelementträger 15 verrastet ist. Hierfür weist das Schirmelement 29 einen Rastabschnitt 30 auf (vgl. Figur 9), der eine radiale und axiale Fixierung mit dem ohnehin vorhandenen Montagezapfen 26 des Kontaktelementträgers 15 eingeht.

Für die elektrische Verbindung mit dem Außenleiterkontaktelement 23 weist das Schirmelement 29 eine Gruppe von ersten Kontaktlaschen 31 auf, die entlang des Außenumfangs verteilt angeordnet sind, wobei grundsätzlich auch bereits eine einzige Kontaktlasche 31 für die Kontaktierung ausreichend sein kann. Die elektrische Kontaktierung mit der elektrischen Leiterplatte 4 bzw. den zugeordneten Außenleiterkontaktflächen 32 (vgl. insbesondere Figur 11) erfolgt über zwei Kontaktklammern 33, die den Aufnahmeschlitz 14 des elektrischen Verbinders 7 seitlich umgeben. Die Kontaktklammern 33 sind dabei jeweils aus zwei sich gegenüberliegenden zweiten Kontaktlaschen 31' ausgebildet, wobei für die Kontaktierung der elektrischen Leiterplatte 4 grundsätzlich auch bereits eine einzige zweite Kontaktlasche 31' ausreichend sein kann.

Es sei erwähnt, dass auf das Schirmelement 29 gegebenenfalls auch vollständig verzichtet werden kann, beispielsweise wenn das Außenleiterkontaktelement 23 selbst eine unmittelbare Kontaktierungsmöglichkeit für die elektrische Schaltungsanordnung 2 ausbildet.

## Patentansprüche

1. Elektrische Baugruppe (3), aufweisend ein Baugruppengehäuse (1), wenigstens eine in dem Baugruppengehäuse (1) aufgenommene elektrische Schaltungsanordnung (2) und einen elektrischen Verbinder (7), der eine Verbindungsschnittstelle (12) aufweist, die elektrisch und mechanisch mit einem korrespondierenden Anschlussbereich (13) der elektrischen Schaltungsanordnung (2) verbunden ist, wobei der elektrische Verbinder (7) durch eine Montagedurchführung (8) des Baugruppengehäuses (1) hindurchgeführt ist, **dadurch gekennzeichnet , dass**
sich die Verbindungsschnittstelle (12) des elektrischen Verbinders (7) und der Anschlussbereich (13) der elektrischen Schaltungsanordnung (2) kraftschlüssig kontaktieren.

2. Elektrische Baugruppe (3) nach Anspruch 1,
**dadurch gekennzeichnet , dass**
sich die Verbindungsschnittstelle (12) des elektrischen Verbinders (7) und der Anschlussbereich (13) der elektrischen Schaltungsanordnung (2) lateral kontaktieren.

3. Elektrische Baugruppe (3) nach Anspruch 1 oder 2,
**dadurch gekennzeichnet , dass**
der Anschlussbereich (13) der elektrischen Schaltungsanordnung (2) zumindest abschnittsweise in der Verbindungsschnittstelle (12) aufgenommen ist, wobei der Anschlussbereich (13) hierzu vorzugsweise in einem Aufnahmeschlitz (14) des elektrischen Verbinders (7) angeordnet ist.

4. Elektrische Baugruppe (3) nach einem der Ansprüche 1 bis 3,
**dadurch gekennzeichnet , dass**
sich der Anschlussbereich (13) der elektrischen Schaltungsanordnung (2) auf zwei gegenüberliegende Hauptflächen (20) der elektrischen Schaltungsanordnung (2) verteilt, die jeweils von der Verbindungsschnittstelle (12) kontaktiert werden.

5. Elektrische Baugruppe (3) nach einem der Ansprüche 1 bis 4,
**dadurch gekennzeichnet , dass**
die Verbindungsschnittstelle (12) für die Verbindung mit dem Anschlussbereich (13) wenigstens eine Kontaktfederlasche (18) aufweist, die eine zugeordnete Kontaktstelle (19) des Anschlussbereichs (13), vorzugsweise eine elektrische Leiterbahn oder eine Kontaktfläche einer elektrischen Leiterplatte (4) der elektrischen Schaltungsanordnung (2), kontaktiert.

6. Elektrische Baugruppe (3) nach einem der Ansprüche 1 bis 5,
**dadurch gekennzeichnet , dass**
das Baugruppengehäuse (1) ein einstückiges, metallisches Bauteil ist, vorzugsweise ein hülsenförmiges oder ein einseitig geöffnetes Bauteil.

7. Elektrische Baugruppe (3) nach einem der Ansprüche 1 bis 6,
**dadurch gekennzeichnet , dass**
die Montagedurchführung (8) in einer geschlossenen Seitenfläche (9) des Baugruppengehäuses (1) in der Art eines Fensters ausgebildet ist.

8. Elektrische Baugruppe (3) nach einem der Ansprüche 1 bis 7,
**dadurch gekennzeichnet , dass**
der elektrische Verbinder (7) an dem Baugruppengehäuse (1) fixiert ist, insbesondere verdrehsicher fixiert ist, vorzugsweise stoffschlüssig fixiert ist.

9. Elektrische Baugruppe (3) nach einem der Ansprüche 1 bis 8,
**dadurch gekennzeichnet , dass**
der elektrische Verbinder (7) und die Montagedurchführung (8) des Baugruppengehäuses (1) so ausgebildet sind, dass der elektrische Verbinder (7) von außerhalb des Baugruppengehäuses (1) mit einem verbindungsschnittstellenseitigen Ende (10) in die Montagedurchführung (8) bis in einen Endmontagezustand einführbar ist, in dem die Verbindungsschnittstelle (12) mit der elektrischen Schaltungsanordnung (2) verbunden ist.

10. Elektrische Baugruppe (3) nach einem der Ansprüche 1 bis 9,
**dadurch gekennzeichnet , dass**
der elektrische Verbinder (7) und die elektrische Schaltungsanordnung (2) eine gegenseitige mechanische Kodierung ausbilden, um eine definierte gegenseitige Ausrichtung vorzugeben und/oder um eine Verdrehsicherung auszubilden.

11. Elektrische Baugruppe (3) nach einem der Ansprüche 1 bis 10,
**dadurch gekennzeichnet , dass**
der elektrische Verbinder (7) ein Außenleiterkontaktelement (23) und einen in dem Außenleiterkontaktelement (23) aufgenommenen Kontaktelementträger (15) aufweist.

12. Elektrische Baugruppe (3) nach Anspruch 11,
**dadurch gekennzeichnet , dass**
der elektrische Verbinder (7) ein Schirmelement (29) aufweist, vorzugsweise ein den Kontaktelementträger (15) hülsenförmig umgebendes Schirmelement (29), das mit dem Außenleiterkontaktelement (23) über wenigstens eine erste Kontaktlasche (31) und mit der elektrischen Schaltungsanordnung (2) über wenigstens eine zweite Kontaktlasche (31') verbunden ist.

13. Elektrische Baugruppe (3) nach einem der Ansprüche 1 bis 12,
**dadurch gekennzeichnet , dass**
die elektrische Schaltungsanordnung (2) eine Trägerplatte, insbesondere eine elektrische Leiterplatte (4), und eine auf der Trägerplatte realisierte elektrische Schaltung (5) aufweist.

14. Elektrische Baugruppe (3) nach einem der Ansprüche 1 bis 13,
**dadurch gekennzeichnet , dass**
der elektrische Verbinder (7) wenigstens ein Kontaktelement (16) aufweist, das sich einstückig entlang einer Längserstreckung des elektrischen Verbinders (7) bis in die Verbindungsschnittstelle (12) erstreckt und die elektrische Schaltungsanordnung (2) in dem Anschlussbereich (13) unmittelbar kontaktiert.

15. Verfahren zur Montage einer elektrischen Baugruppe (3), aufweisend zumindest die folgenden Verfahrensschritte:
- Bereitstellen eines Baugruppengehäuses (1) und einer in dem Baugruppengehäuse (1) aufgenommenen elektrischen Schaltungsanordnung (2);
- Bereitstellen eines elektrischen Verbinders (7), der eine Verbindungsschnittstelle (12) zur Verbindung mit der elektrischen Schaltungsanordnung (2) aufweist;
- Hindurchführen des elektrischen Verbinders (7) durch eine Montagedurchführung (8) des Baugruppengehäuses (1), bis die Verbindungsschnittstelle (12) elektrisch und mechanisch mit einem korrespondierenden Anschlussbereich (13) der elektrischen Schaltungsanordnung (2) verbunden ist,
**dadurch gekennzeichnet , dass**
sich die Verbindungsschnittstelle (12) des elektrischen Verbinders (7) und der Anschlussbereich (13) der elektrischen Schaltungsanordnung (2) in dem montierten Zustand kraftschlüssig kontaktieren.
